(19) **Europäisches Patentamt**

**European Patent Office**

**Office européen des brevets**

(11) **EP 0 741 195 A1**

(12) **EUROPÄISCHE PATENTANMELDUNG**

(43) Veröffentlichungstag:
06.11.1996 Patentblatt 1996/45

(51) Int. Cl.⁶: **C23C 16/02**, C23C 16/26, C23C 28/00

(21) Anmeldenummer: 96105346.9

(22) Anmeldetag: 03.04.1996

(84) Benannte Vertragsstaaten:
**AT BE CH DE FR GB IT LI LU SE**

(30) Priorität: **07.04.1995 DE 19513102**

(71) Anmelder: **FRAUNHOFER-GESELLSCHAFT ZUR FÖRDERUNG DER ANGEWANDTEN FORSCHUNG E.V.
80636 München (DE)**

(72) Erfinder:
• **Dietz, Andreas, Dr.
38304 Wolfenbüttel (DE)**
• **Klages, Claus-Peter, Dr.
38102 Braunschweig (DE)**
• **Bluhm, Andrea, Dipl.-Ing.
22303 Hamburg (DE)**
• **Schäfer, Lothar, Dipl.-Phys.
22523 Hamburg (DE)**

(54) **Diamant-Compositschichtsystem, Verfahren zu seiner Herstellung und seine Verwendung**

(57) Die Erfindung betrifft ein Diamant-Compositschichtsystem auf Substraten, ein mögliches Verfahren zu seiner Herstellung und seine Verwendung. Dieses Diamant-Compositschichtsystem auf Substraten besteht aus einer auf dem Substrat haftenden Dispersionsschicht sowie einer darauf aufgebrachten Diamantschicht. Erfindungsgemäß weist die Dispersionsschicht eine Dicke zwischen 0,1 und 100 µm auf und besteht aus einer ersten elektrisch leitenden Phase und einer zweiten elektrisch nichtleitenden Phase, die einen Volumenanteil der Dispersionsschicht zwischen 0,1 und 60 % ausmacht. Die Diamantschicht weist eine Dicke zwischen 1 und 100 µm auf. Das Diamant-Compositschichtsystem wird erfindungsgemäß in zwei Prozeßschritten hergestellt, indem in einem ersten Prozeßschritt die Dispersionsschicht und in einem zweiten Prozeßschritt auf dieser die Diamantschicht nach einem Niederdruck-Syntheseverfahren aus der Gasphase abgeschieden wird.

**Beschreibung**

Die Erfindung betrifft ein Diamant-Compositschichtsystem, insbesondere auf Werkzeugen und Bauteilen aus Hartmetall oder Stählen, ein Verfahren zu seiner Herstellung und einige Verwendungsmöglichkeiten dieses Diamant-Compositschichtsystems. Die Erfindung ist einem breiten Anwendungsfeld zugänglich und überall dort vorteilhaft einsetzbar, wo Beschichtungen mit besonderen und definierten Eigenschaften auf Werkzeugen gefordert werden.

Diamant zeichnet sich durch seine große Härte und chemische Resistenz aus. Aufgrund dieser Eigenschaften besitzt er eine sehr hohe Verschleißbeständigkeit. Die Entwicklung der Niederdruck-Diamantsynthese [K.E. Spear; J. Am. Ceram. Soc. 72 (1989) 171-174] erlaubt es, polykristalline Diamantschichten aus einer aktivierten Gasphase direkt auf verschiedene Substratmaterialien und -geometrien abzuscheiden. Die Diamantbeschichtung von Werkzeugen und Bauteilen aus Siliciumnitrid und anderen Si-haltigen Keramiken wurde bereits an vielen Stellen erfolgreich durchgeführt. Dabei wurde zum Teil eine erhebliche Verschleißreduktion und Standzeitverlängerung nachgewiesen. Bei der Beschichtung von Hartmetallwerkzeugen wurde zwar ebenfalls eine deutliche Reduktion des Verschleisses beobachtet [B. Lux, R. Haubner, P. Renard; Diamond and Related Materials 1(1992)1035-1047], jedoch konnte aufgrund mangelnder Haftung der Diamantschichten keine Standzeitverlängerung erzielt werden. Ein wesentlicher Grund für die nicht ausreichende Haftung auf Hartmetall ist der nachteilige Einfluß des Cobalt-Bindermaterials auf die Diamantabscheidung [A.K. Mehlmann, S. F. Dirnfeld, Y. Avigal; Proc. of Diamond Films '91 (1991)].

Wegen der starken Interdiffusion zwischen Diamant und Stahl unter Diamantdepositionsbedingungen ist die direkte Abscheidung nicht ohne erhebliche Änderungen im Stahlgrundkörper möglich. Daher werden in diesen Fällen Zwischenschichten, die entweder mit physikalischer oder chemischer Gasphasenabscheidung aufgebracht werden, untersucht. Diese Methoden sind in der Regel durch geringe Wachstumsraten gekennzeichnet. Daher lassen sich damit nur dünne Zwischenschichten wirtschaftlich abscheiden, die lediglich als Diffusionsbarrieren geeignet sind [J. Spinnewyn, M. Nesladék, C. Asinari; Diamond and Related Materials 2,2 (1993) 361 und M. Nesladék, J. Spinnewyn, C. Asinari, R. Lebout; Diamond and Related Materials 3,1 (1993) 98].

Der große Unterschied zwischen Diamant und Stahl hinsichtlich Härte und thermischer Ausdehnung erfordert für die Herstellung eines haftfesten und tragfähigen Schicht-Substrat-Verbundes jedoch eine Anpassung der Eigenschaften, wie sie nur über relativ dicke Zwischenschichten erzielt werden kann.

Im Bereich der Herstellung von Schleifwerkzeugen sind Arbeiten bekannt, die sich mit der Einbindung von Abrasivkristallen, vorzugsweise cBN (kubisches Bornitrid) oder Diamant in galvanisch abgeschiedenen Schichten befassen [DE 42 15 525 und DE 42 07 510]. Hierbei handelt es sich nicht um ein mehrlagiges Schichtsystem, sondern um die Verankerung einzelner Diamant- bzw. cBN-Kristalle mittels eines metallischen Binders.

Die hier beschriebenen Lösungen haben den Nachteil, daß keine geeigneten Zwischenschichten für die Abscheidung haftfester, tragfähiger Diamantschichten auf Hartmetallen und Stählen herstellbar sind. Eine Optimierung der Schichtstruktur ist mit diesem Verfahren nicht bzw. nur schwer möglich.

Desweiteren sind Arbeiten von Tsai u.a. [C. Tsai, J. Nelson, W. Gerberich, J. Heberlein, E. Pfendner; Mat. Res. Soc. Proc. Vol. 239 (1992) 275] bekannt. In dem dort beschriebenen Verfahren benutzen Tsai u.a. einen dreiteiligen Prozeß zur Abscheidung von Metall/Diamant-Compositschichten. In einem ersten Schritt bringen sie direkt auf das Substrat eine dünne und nicht geschlossene Diamantschicht auf. Diese Diamantpartikel werden in einem zweiten Schritt durch die galvanische Abscheidung einer dünnen Nickelschicht mechanisch verankert. Diese muß so beschaffen sein, daß die Diamantpartikel aus der Ni-Schicht herausragen. Sie dienen in der lezten Phase des Prozesses, der CVD-Diamantabscheidung, als Kristallisationskeime.

Ein ähnliches Verfahren benutzten Shih und Mitarbeiter zur Herstellung von Kompositschichten. Sie benutzten eine außenstromlose Nickelbeschichtung, um die gleichfalls im MWP-CVD-Prozeß hergestellten Kristallisationskeime aus Diamant einzubetten. Durch alternierende Prozeßführung (Ni-Diamant-Ni) entsteht ebenfalls eine diamanthaltige Nickeldispersionsschicht [H.C. Shih, W. T. Hsu, C. T. Hwang, C. P. Sung, L. K. Lin, C. K. Lee; Thin Solid Films 236 (1993) 111].

Diese hier beschriebenen Verfahren sind aufgrund ihrer Langwierigkeit und Komplexität sehr zeit- und kostenaufwendig.

Es ist nunmehr Aufgabe der Erfindung, ein Diamant-Compositschichtsystem anzugeben und ein Verfahren zu seiner Abscheidung vorzuschlagen, mit denen sämtliche Nachteile des Standes der Technik beseitigt werden.

Es ist somit Aufgabe der Erfindung, ein Diamant-Compositschichtsystem vorzuschlagen, das eine Zwischenschicht enthält, die für die Abscheidung haftfester und tragfähiger Diamantschichten geeignet ist, als Diffusionsbarriere wirkt, deren Härte und Ausdehnungskoeffizient definiert einstellbar ist und die wirtschaftlich auf Werkzeugen und Bauteilen aufgebracht werden kann.

Darüber hinaus ist es Aufgabe der Erfindung, ein Verfahren zur Abscheidung von Diamant-Compositschichtsystemen anzugeben, das wirtschaftlich ist und mit dem für die Abscheidung haftfester, tragfähiger Diamantschichten auf insbesondere Hartmetallen und Stählen geeignete Zwischenschichten herstellbar sind.

Schließlich ist es noch Aufgabe der Erfindung, einige Verwendungsmöglichkeiten der erfindungsgemäßen Diamant-Compositschichtsysteme aufzuzeigen.

Erfindungsgemäß werden diese Aufgaben mit einem Diamant-Compositschichtsystem gemäß einem oder mehreren der Ansprüche 1 bis 6, mit einem Verfahren gemäß einem oder mehreren der Ansprüche 7 bis 16 und mit einer Verwendung gemäß einem oder mehreren der Ansprüche 17 bis 20 gelöst.

Das erfindungsgemäße Diamant-Compositschichtsystem, welches in einem zweistufigen Prozeß abscheidbar ist, besteht aus einer auf das Substrat haftfest aufgebrachten Dispersionsschicht und einer darauf haftenden Diamantschicht. Letztere ist mit einer Dicke zwischen 1 und 100 $\mu$m auf der Dispersionsschicht abgeschieden.

Die Dispersionsschicht des erfindungsgemäßen Diamant-Compositschichtsystems hat eine Dicke zwischen 0,1 und 100 $\mu$m und besteht aus einer ersten, elektrisch leitenden und einer zweiten elektrisch nichtleitenden Phase, wobei diese zweite Phase einen Volumenanteil der Dispersionsschicht von 0,1 bis 60 %, was vom konkreten Anwendungsfall abhängt, ausmacht. Während die erste Phase der Dispersionsschicht aus einem oder mehreren Metallen und/oder einer oder mehreren Metallegierungen, vorzugsweise Fe, Co und/oder Ni bzw. Legierungen dieser Metalle und/oder Cr, wobei die besten Resultate beim Einsatz von Cr allein erzielt wurden, besteht, wird die zweite Phase günstigerweise von Diamantpartikeln und/oder Partikeln aus kubischem Bornitrid gebildet. Diese Partikel der zweiten Phase der Dispersionsschicht sollten vorteilhafterweise Abmessungen zwischen 0,01 und 10 $\mu$m aufweisen.

Das Verfahren zur Abscheidung eines Diamant-Compositschichtsystems auf einem Substrat wird erfindungsgemäß in nur zwei Prozeßschritten durchgeführt. Dabei wird in einem ersten Prozeßschritt eine Dispersionsschicht, die sich aus einer ersten, elektrisch leitenden Phase, bestehend aus einem oder mehreren Metallen und/oder einem oder mehreren Metallegierungen, vorzugsweise Fe, Co und/oder Ni bzw. Legierungen dieser Metalle und/oder Cr (am günstigsten erwies sich der Einsatz von Cr allein) und einer zweiten elektrisch nichtleitenden Phase, die einen Volumenanteil zwischen 0,1 und 60 % der Dispersionsschicht ausmachen sollte, zusammensetzt und eine Schichtdicke zwischen 0,1 und 100 $\mu$m hat, abgeschieden. In einem zweiten Prozeßschritt erfolgt dann die Abscheidung einer CVD-Diamantschicht mit einer Schichtdicke zwischen 1 und 100 $\mu$m nach einem Niederdruck-Syntheseverfahren, vorzugsweise Mikrowellenplasma - CVD - oder Heißdraht - CVD - Verfahren, aus der Gasphase. Zur Abscheidung der Diamantschicht auf der Dispersionsschicht ist auch die Anwendung anderer herkömmlicher Verfahren zur Abscheidung von Diamantschichten möglich.

Die Abscheidung der Dispersionsschicht auf dem Substrat im ersten Prozeßschritt des erfindungsgemäßen Verfahrens erfolgt vorteilhafterweise galvanisch oder außenstromlos. Dabei werden in einem metallsalzhaltigen Elektrolyten, wobei hier der Metallanteil aus dem oder den Metallen besteht, die die erste Phase der Dispersionsschicht bilden, die Partikel der die zweite Phase der Dispersionsschicht bildenden Substanzen, vorzugsweise Diamantpartikel und/oder Partikel aus kubischem Bornitrid, wobei es sich als günstig erwiesen hat, wenn diese Partikel Abmessungen zwischen 0,01 und 10 $\mu$m haben, durch starkes Rühren suspendiert. In diese Suspension werden das Substrat, welches als Kathode geschaltet wird, und eine Anode getaucht. Durch Anlegen einer Spannung zwischen dem in die Suspension getauchten Substrat und der Anode scheidet sich eine diamant- und/oder bornitridhaltige Metallschicht auf dem Substrat ab. Die sich so bildende Dispersionsschicht enthält in sich fest haftende Diamantpartikel und/oder Partikel aus kubischem Bornitrid.

Abhängig von der Größe und Konzentration der kubischen Bornitrid- und/oder Diamantpartikel in der Zwischenschicht werden die Eigenschaften dieser Schicht nicht nur von den Eigenschaften des abgeschiedenen Metalls bestimmt, sondern auch durch diese in der Schicht verteilten Teilchen. Dadurch ist es möglich, neben Chrom, welches elektrolytisch abgeschieden das härteste Metall darstellt, noch andere Metalle als Matrix für Dispersionsschichten einzusetzen. Auch die Kinetik der nachfolgenden Diamantabscheidung wird von diesen in der Dispersionsschicht verteilten Partikeln beeinflußt. So ließ sich z.B. Diamant auf einer Ni/Diamant-Compositschicht abscheiden, obwohl bekannt ist, daß die Diamantbildung auf den Elementen der Eisengruppe (Eisen, Cobalt, Nickel) erschwert ist, da sich auf diesen Metallen bevorzugt Graphit bildet [Y. Saito, K. Sato, S. Matuda; J. Mat. Sci. 26 (1991) 2937-2940]. Die Haftung der Diamantschicht verbessert sich, da das Wachstum direkt auf den in der Dispersionsschicht verankerten kubischen Bornitrid- und/oder Diamantpartikeln stattfindet.

Die Haftung der Compositschicht auf dem Werkstück ist abhängig von dem Material des zu beschichtenden Teils, der vorausgegangenen Reinigung sowie der Wahl der Elektrolyten. Dabei werden die Vorschriften der Galvanotechnik angewandt.

Es hat sich als zusätzlich vorteilhaft herausgestellt, der Dispersionsschicht eine besondere Morphologie, erreichbar durch beispielsweise ausgeprägte Porosität, dentritisches Wachstum und/oder Mikrorisse, zu geben.

Die zusätzlich als Diffusionsbarriere wirkenden Zwischenschichten werden mit galvanischen oder außenstromlosen Verfahren als diamant- und/oder bornitridhaltige Dispersions-schichten mit einstellbarer Härte und Ausdehnungskoeffizienten wirtschaftlich auf beispielsweise Werkzeugen und Bauteilen abgeschieden. Die allgemeine Reaktionsgleichung hierfür lautet

$$Me^{n+} + ne^- + D/BN_{susp} \rightarrow Me\ D/BN$$

wobei

$Me^{n+}$     - in der Suspension enthaltene n-fach geladene Metallkationen

$ne^-$     - die entsprechenden Elektronen zu $Me^{n+}$

$D/BN_{susp}$     - in der Suspension enthaltene Diamant- und/oder kubische Bornitridpartikel

Me D/BN     - Zusammensetzung der Dispersionsschicht, enthaltend Metall (Me) und Diamant und/oder kubisches Bornitrid (D/BN)

bedeuten.

In dem Verfahren werden diamanthaltige Dispersionsschichten als Zwischenschichten galvanisch auf die Grundkörper abgeschieden. Im Gegensatz zur Substratoberfläche lassen sich auf den Zwischenschichten polykristalline Diamantschichten mittels Niederdruck-Diamantsynthese direkt abscheiden. Dadurch wird es möglich, z.B. Wendeschneidplatten oder Bohrer aus Stahl oder Werkzeuge für die Kunststoffbearbeitung mit einer haftfesten Verschleißschutzschicht aus CVD-Diamant zu beschichten. Ebenfalls ist es möglich, elektrisch isolierende Schutzschichten aus Diamant herzustellen.

Die besonderen Vorteile dieses Schichtsystems und des Verfahrens gegenüber dem Stand der Technik bestehen in den folgenden Punkten:

- Die hier beschriebenen Dispersionsschichten stellen Barrieren für die Interdiffusion zwischen der Diamantschicht und dem Grundkörper dar.

- Die galvanischen Dispersionsschichten, bestehend aus einer metallischen Matrix und darin eingelagerten Diamantpartikeln und/oder Partikeln aus kubischem Bornitrid lassen sich durch Wahl des Matrixmaterials und durch Anzahl und Größe der eingelagerten Partikel hinsichtlich thermischem Ausdehnungskoeffizienten und ihrer Härte variieren.

- Durch Anpassung der Dispersionszwischenschichten an das Material des Werkzeug- bzw. Bauteilgrundkörpers läßt sich die Haftfestigkeit der Diamantschichten deutlich verbessern.

- Verbesserung der Haftung von polykristallinen Diamantschichten durch

  - ausgezeichnete Barriereeigenschaften der Dispersionsschicht
  - Anpassung des Ausdehnungskoeffizienten durch Variation von Schichtzusammensetzung und -dicke der Dispersionsschicht
  - mechanische und chemische Verankerung der Diamantschicht mit der Zwischenschicht
  - Optimierung der Schichtstruktur (dicht, porös, dendritisch, mikrorissig) durch Variation der Abscheideparameter

- Verbesserung der Tragfähigkeit des Schicht-Substrat-Verbundes - durch Anpassung der Härte mittels Variation von Schichtzusammensetzung und -dicke

- Kostengünstige Abscheidung (z.B. dadurch, daß nur zwei Prozeßschritte notwendig sind).

Das erfindungsgemäße Diamant-Compositschichtsystem ist einem breiten Anwendungsgebiet zugänglich. Besonders vorteilhaft ist sein Einsatz als Beschichtung auf Werkzeugen für abtragende, umformende oder einebnende Materialbearbeitung, als Beschichtung auf Werkzeugen für die Verarbeitung von Kunststoff, als verschleißfeste Beschichtung auf Bauteilen oder als elektrische Isolationsschicht.

Die Nachteile des Standes der Technik werden mit dem erfindungsgemäßen Diamant-Compositschichtsystem sowie mit dem erfindungsgemäßen Verfahren zu seiner Herstellung beseitigt.

Die Erfindung wird im nachfolgenden Ausführungsbeispiel näher erläutert. Die Abildung illustriert dabei schematisch den Aufbau eines Diamant-Compositschichtsystems, bestehend aus einer Chrom-Diamant-Dispersionsschicht und einer CVD-Diamantschicht.

**Ausführungsbeispiel**

Aufbringung einer Cr/Diamant-Compositschicht auf einen St 37 mit nachgeschalteter Niederdruck-Diamantsynthese:

1. Die Reinigung des Stahls wurde nach üblichen Verfahren der galvanischen Reinigung durchgeführt. Nach der elektrolytischen Entfettung in konzentrierter Natronlauge und nachfolgendem Spülen wurde die Probe in verdünnter Schwefelsäure dekapiert und danach gründlich in demineralisiertem Wasser gespült.

2. Die Probe wurde in einen Elektrolyten mit der Zusammensetzung 350g/l Chromsäure, 2,5g/l Schwefelsäure und 50g/l Diamantpulver (Teilchendurchmesser 1-3 μm) eingebracht. Mittels Magnetrührer wurde die Suspension intensiv gerührt. Die Temperatur des Elektrolyten betrug 23°C, als Stromdichte wurden 20A/dm$^2$ eingestellt. Als Anode wurde ein Pt-Blech verwendet. die Abscheidedauer betrug 15 Minuten.

3. Nach dem Spülen und Trocknen der Probe folgte die Niederdruck-Diamantsynthese nach dem Mikrowellenplasma-CVD-Verfahren. Die Probe wurde vor der Beschichtung 10 Minuten im Wasserstoffplasma geätzt. Als Gas für die Diamantbeschichtung wurde ein Gemisch von 0,4% Methan in Wasserstoff verwendet bei einem Druck von 20mbar und einem Gasfluß von 500sccm (Standardkubikzentimeter pro Minute). Die Beschichtungstemperatur lag bei 630°C, die Beschichtungszeit betrug 18 Stunden.

Das so hergestellte Diamant-Compositschichtsystem ist in Abb. 1 schematisch dargestellt. Auf dem Substrat 1 (St 37) haftet die Dispersionsschicht 2 mit einer Schichtdicke von 4 mm mit eingebetteter 2. Phase, bestehend in diesem Beispiel aus Diamantpartikeln in Cr. Auf der Dispersionsschicht 2 wiederum haftet eine 3μm dicke CVD-Diamant-schicht, die im Beispiel mittels Heißdraht-CVD-Verfahren abgeschieden wurde.

**Abb.1:** Schema des Aufbaus eines Compositschichtsystems

**Aufstellung der verwendeten Bezugszeichen und Begriffe**

1 Substrat

2 Dispersionsschicht

3 Diamantschicht

## Patentansprüche

1. Diamant-Compositschichtsystem auf Substraten, bestehend aus einer auf dem Substrat haftenden Dispersionsschicht und einer darauf aufgebrachten Diamantschicht, **dadurch gekennzeichnet**, daß die Dispersionsschicht eine Dicke zwischen 0,1 und 100 μm aufweist und aus einer ersten elektrisch leitenden Phase, bestehend aus einem oder mehreren Metallen und/oder einer oder mehreren Metallegierungen, und einer zweiten, elektrisch nichtleitenden Phase, die einen Volumenanteil zwischen 0,1 und 60 % der Dispersionsschicht ausmacht, und die Diamantschicht eine Dicke zwischen 1 und 100 μm auf der Dispersionsschicht aufweist.

2. Diamant-Compositschichtsystem nach Anspruch 1, **dadurch gekennzeichnet**, daß dieses Diamant-Compositschichtsystem in einem 2-stufigen Prozeß auf dem Substrat abscheidbar ist.

3. Diamant-Compositschichtsystem nach Anspruch 1 oder 2, **dadurch gekennzeichnet**, daß die erste Phase der Dispersionsschicht aus den Metallen Fe, Co und/oder Ni bzw. Legierungen dieser Metalle und/oder Cr besteht.

4. Diamant-Compositschichtsystem nach Anspruch 3, **dadurch gekennzeichnet**, daß die erste Phase der Dispersionsschicht aus Cr besteht.

5. Diamant-Compositschichtsystem nach einem oder mehreren der Ansprüche 1 bis 4, **dadurch gekennzeichnet**, daß die zweite Phase der Dispersionsschicht aus Diamantpartikeln und/oder aus Partikeln aus kubischem Bornitrid besteht.

6. Diamant-Compositschichtsystem nach Anspruch 5, **dadurch gekennzeichnet**, daß diese Partikel Abmessungen zwischen 0,01 und 10 $\mu$m aufweisen.

7. Verfahren zur Abscheidung eines Diamant-Compositschichtsystems auf einem Substrat, **dadurch gekennzeichnet**, daß diese Abscheidung in nur zwei Prozeßschritten durchgeführt wird, indem in einem ersten Prozeßschritt eine Dispersionsschicht, die sich aus einer ersten elektrisch leitenden Phase, bestehend aus einem oder mehreren Metallen und/oder einer oder mehreren Metallegierungen, und einer zweiten, elektrisch nichtleitenden Phase zusammensetzt, mit einer Schichtdicke zwischen 0,1 und 100 $\mu$m abgeschieden wird und in einem zweiten Prozeßschritt auf dieser Dispersionsschicht eine CVD-Diamantschicht mit einer Schichtdicke zwischen 1 und 100 $\mu$m nach einem Niederdruck-Syntheseverfahren aus der Gasphase abgeschieden wird.

8. Verfahren nach Anspruch 7, **dadurch gekennzeichnet**, daß die Dispersionsschicht galvanisch oder außenstromlos auf dem Substrat abgeschieden wird.

9. Verfahren nach Anspruch 8, **dadurch gekennzeichnet**, daß die Dispersionsschicht abgeschieden wird, indem in einem metallsalzhaltigen Elektrolyten Partikel der die zweite Phase der Dispersionsschicht bildenden Substanzen durch Rühren suspendiert werden, in diese Suspension das Substrat, welches als Kathode geschaltet wird, und eine Anode getaucht werden und eine Spannung angelegt wird.

10. Verfahren nach einem oder mehreren der Ansprüche 7 bis 9, **dadurch gekennzeichnet**, daß die erste Phase der Dispersionsschicht durch Fe, Co und/oder Ni bzw. Legierungen dieser Metalle und/oder Cr gebildet wird.

11. Verfahren nach Anspruch 10, **dadurch gekennzeichnet**, daß die erste Phase der Dispersionsschicht durch Cr gebildet wird.

12. Verfahren nach einem oder mehreren der Ansprüche 7 bis 10, **dadurch gekennzeichnet**, daß die zweite Phase der Dispersionsschicht von Diamantpartikeln und/oder Partikeln aus kubischem Bornitrid gebildet wird.

13. Verfahren nach Anspruch 12, **dadurch gekennzeichnet**, daß diese Partikel Abmessungen zwischen 0,01 und 10 $\mu$m aufweisen.

14. Verfahren nach einem oder mehreren der Ansprüche 7 bis 13, **dadurch gekennzeichnet**, daß der Dispersionsschicht eine besondere Morphologie gegeben wird.

15. Verfahren nach Anspruch 14, **dadurch gekennzeichnet**, daß dies durch eine ausgeprägte Porosität, durch dentritisches Wachstum und/oder durch Mikrorisse erreicht wird.

16. Verfahren nach einem oder mehreren der Ansprüche 7 bis 15, **dadurch gekennzeichnet**, daß als Niederdrucksynthese-Verfahren zur Abscheidung der CVD-Diamantschicht das Mikrowellenplasma - CVD - oder das Heißdraht - CVD - Verfahren benutzt werden.

17. Verwendung des Diamant-Compositschichtsystems gemäß einem oder mehreren der Ansprüche 1 bis 6, das nach einem Verfahren gemäß einem oder mehreren der Ansprüche 7 bis 16 abgeschieden sein kann als Beschichtung auf Werkzeugen für abtragende, umformende oder einebnende Materialbearbeitung.

18. Verwendung des Diamant-Compositschichtsystems gemäß einem oder mehreren der Ansprüche von 1 bis 6, das nach einem Verfahren gemäß einem oder mehreren der Ansprüche 7 bis 16 abgeschieden sein kann als Beschichtung auf Werkzeugen für die Verarbeitung von Kunststoffen.

19. Verwendung des Diamant-Compositschichtsystems gemäß einem oder mehreren der Ansprüche 1 bis 6, das nach einem Verfahren gemäß einem oder mehreren der Ansprüche 7 bis 16 abgeschieden sein kann, als verschleißfeste Beschichtung auf Bauteilen.

20. Verwendung des Diamant-Compositschichtsystems gemäß einem oder mehreren der Ansprüche 1 bis 6, das nach einem Verfahren gemäß einem oder mehreren der Ansprüche 7 bis 16 abgeschieden sein kann, als elektrische Isolationsschicht.

| | Europäisches Patentamt | EUROPÄISCHER RECHERCHENBERICHT | | Nummer der Anmeldung EP 96 10 5346 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | DIAMOND AND RELATED MATERIALS, 25 JUNE 1992, NETHERLANDS, Bd. 1, Nr. 8, ISSN 0925-9635, Seiten 907-910, XP000349652 RAMESHAM R ET AL: "Selective diamond seed deposition using electroplated copper" | 1-3, 5-10, 12-14, 16-20 | C23C16/02 C23C16/26 C23C28/00 |
| Y | * das ganze Dokument * | 4,11 | |
| A | | 15 | |
| | --- | | |
| X | WO-A-93 11273 (UNIV MINNESOTA) 10.Juni 1993 | 1-3,5,6 | |
| Y | * Seite 11, Zeile 9 - Zeile 23 * | 4,11 | |
| A | * Seite 16, Zeile 19 - Zeile 26 * | 7-10, 12-20 | |
| | * Seite 19, Zeile 1 - Zeile 23 * | | |
| | --- | | |
| X | US-A-5 298 286 (YANG PEICHUN ET AL) 29.März 1994 * Spalte 7, Zeile 31 - Spalte 9, Zeile 25 * | 1-6, 17-20 | |
| | ----- | | RECHERCHIERTE SACHGEBIETE (Int.Cl.6) C23C |

Der vorliegende Recherchenbericht wurde für alle Patentansprüche erstellt

| Recherchenort | Abschlußdatum der Recherche | Prüfer |
|---|---|---|
| DEN HAAG | 15.Juli 1996 | Ekhult, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
..............
& : Mitglied der gleichen Patentfamilie, übereinstimmendes Dokument

EPO FORM 1503 03.82 (P04C03)